(19) Europäisches Patentamt
European Patent Office
Office européen des brevets

(11) Publication number: **0 196 561 B1**

(12) # EUROPEAN PATENT SPECIFICATION

(45) Date of publication of patent specification: **14.06.89**

(51) Int. Cl.⁴: **G 03 C 1/68,** C 08 F 2/50

(21) Application number: **86103804.0**

(22) Date of filing: **20.03.86**

(54) **Photosensitive lithographic printing plate.**

(30) Priority: **20.03.85 JP 54388/85**

(43) Date of publication of application:
**08.10.86 Bulletin 86/41**

(45) Publication of the grant of the patent:
**14.06.89 Bulletin 89/24**

(84) Designated Contracting States:
**DE FR GB**

(56) References cited:
**EP-A-0 028 749**
**EP-A-0 125 140**
**EP-A-0 126 541**
**FR-A-2 532 768**
**GB-A-1 566 405**
**US-A-3 255 006**

**The file contains technical information submitted after the application was filed and not included in this specification**

(73) Proprietor: **NIPPON OIL AND FATS COMPANY, LIMITED**
**10-1, Yuraku-cho 1-chome**
**Chiyoda-ku Tokyo (JP)**

(72) Inventor: **Goto, Yoshitaka**
**2-24-5, Umezono Sakuramura**
**Niihari-gun Ibaragi-ken (JP)**
Inventor: **Fujii, Kenichi**
**2-24-5, Umezono Sakuramura**
**Niihari-gun Ibaragi-ken (JP)**
Inventor: **Hayashi, Akio**
**Shatore Amakubo A-201 2-6-3, Amakubo Sakuramura**
**Niihari-gun Ibaragi-ken (JP)**
Inventor: **Yamada, Eiichi**
**2-15-5, Umezono Sakuramura**
**Niihari-gun Ibaragi-ken (JP)**

(74) Representative: **Strehl, Schübel-Hopf, Groening, Schulz**
**Maximilianstrasse 54 Postfach 22 14 55**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 196 561 B1

**Description**

The present invention relates to a photosensitive lithographic printing plate, and more particularly to a photosensitive lithographic printing plate having extremely high sensitivity so that a printing image can be formed by the laser plate making process and the thus formed image can be developed by a weakly alkaline aqueous solution.

In the field of lithographic printing, so-called PS plates, *i.e.* presensitized plates prepared by using diazo type photosensitive materials, have been widely used.

Chemically resistant photosensitive resin compositions are known from US—A—3 255 006. These compositions comprise a polymer such as a polyester resin having an acid number of 10 to 20, styrene, benzoyl peroxide and a dye. EP—A—125 140 describes a radiation sensitive plate for lithographic printing comprising a photopolymerizable composition containing an ethylenically unsaturated compound, a binder, such as dimethacrylate ester, a peroxy ester, such as perbenzoate and sensitizers, such as cyanine dyes. FR—A—2 532 768 describes photosensitive layers containing organic peroxides, pyrylium salts, ethylenically unsaturated compounds and suitable polymerizable binders, like N-vinylpyrrolidone. Other suitable binders for photosensitive layers are also described in EP—A—38 749 where acidic polymers are used for photosensitive lithographic printing plates which can be processed and developed in aqueous alkaline solutions. Peroxide compounds or sensitizers for the use in photopolymerizable materials are also described in EP—A—126 541 and GB—A—1 566 405. However, the conventional presensitized plates or photopolymerizable materials are either low in photosensitivity or are sensitive only to near UV light or cannot be developed and processed in aqueous alkaline solutions.

It has been proposed recently that the process efficiency can be greatly improved by exposing a green or immaculate plate with laser or other focused light directly without any intermediate masking by a high speed scanning controlled by a computer. However, this conspicuous proposal has not yet been used practically for the attendant problem that scanning exposure of the conventional photosensitive lithographic plate requires large output untraviolet laser, leading to increase in investment for the equipment including a large scale optical system with increase in consumed electrical power in addition to reduction in lifetime of the laser generating system.

The object of this invention is to provide a photosensitive lithographic printing plate having extremely high sensitivity to a wide wavelength range including the visible light range and which has extremely high sensitivity particularly to the output lines of visible laser lights and does not show the reciprocity low failure even when exposed to a high illumination light for extremely short time during the high speed scanning exposure process.

The photosensitive lithographic printing plate of this invention may be easily developed by the use of an ordinary aqueous developing solution to form an image including printing areas on which a printing ink can be coated or spread in a satisfactory condition.

The above and other objects and advantages of the invention will become apparent from the following detailed description thereof.

By this invention there is provided a photosensitive lithographic printing plate comprising a supporting substrate and a photosensitive layer carried on said supporting substrate, said photosensitive layer containing a polymer (a) having an acid number of not more than 200, an addition polymerizable compound (b) having at least one ethylenically unsaturated double bond, an organic peroxide (c) and a compound (d) absorbing visible light, which is characterized in that said organic peroxide (c) is a polyperoxy ester containing a benzophenone group and represented by the following general formula (I):

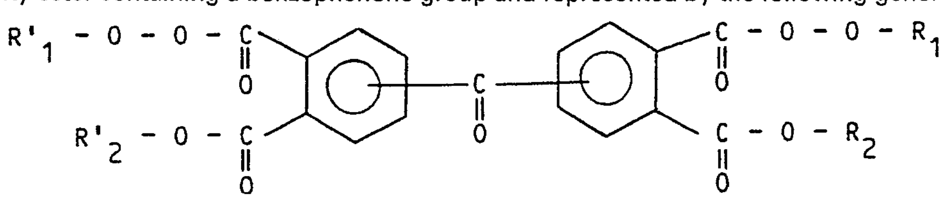

(I)

wherein each of $R_1$ and $R_1'$ represents the same or a different group and is a tertiary alkyl group having 4 to 8 carbon atoms or a tertiary aralkyl group having 9 to 12 carbon atoms, and each of $R_2$ and $R_2'$ represents the same or different atom or group and is a hydrogen atom, a tertiary alkoxy group having 4 to 8 carbon atoms or a tertiary aralkyloxy group having 9 to 12 carbon atoms, and said compound (d) absorbing visible light is a pyrylium salt compound represented by the following general formula (II):

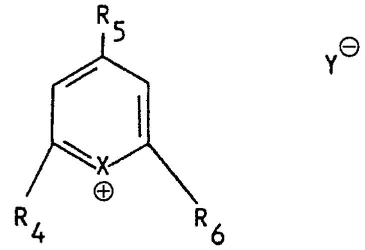

(II)

wherein each of $R_4$, $R_5$ and $R_6$ represents the same or different atom or group and is a hydrogen atom, a halogen atom, an alkyl group, a haloalkyl group, an ethylenyl group, a styryl group, an alkoxy group, a phenyl group, a naphthyl group, an alkylphenyl group, an alkoxyphenyl group, a hydroxyphenyl group, a halophenyl group, a nitrophenyl group, an aminophenyl group, a nitro group, an amino group or a hydroxyl group, X is an oxygen atom or a sulfur atom, and Y is an anionic functional group.

The present invention will now be described in detail hereinbelow.

The photosensitive lithographic printing plate of the invention comprises a supporting substrate and a photosensitive layer carried on the supporting substrate. The photosensitive layer includes a polymer (a) having an acid number of not more than 200, an addition polymerizable compound (b) having at least one ethylenically unsaturated double bond per molecule, an organic polyperoxy ester containing a benzophenone group (c) and a pyrylium salt compound (d) absorbing visible light.

Any of vinyl system polymers of addition polymerization product and polycondensation polymers of polyester system, polyurethane system and polyamide system may be used as the polymer (a) having an acid number of not more than 200 as far as they have weight average molecular weight of about 10,000 to 500,000. Preferable examples of such polymers are copolymers of (meth)acrylic acid, (methacrylates, maleic acid, fumaric acid, maleates, fumarates, ethylene glycol, styrene and vinyl chlorides; specific examples being copolymers of methyl methacrylate/ethyl acrylate/benzyl methacrylate/methacrylic acid, copolymers of methyl methacrylate/butyl methacrylate/methacrylic acid, copolymers of styrene/maleic acid/dimethyl maleate/vinyl chloride, copolymers of tetrahydrophthalic anhydride/fumaric acid/diethylene glycol, and copolymers of methyl methacrylate/ethyl acrylate/butyl methacrylate/methacrylic acid.

If the acid value of the polymer (a) is more than 200, the solubility of the photosensitive layer becomes excessively high so that the printing area is apt to be rinsed away by a weak alkaline aqueous solution used as the developing solution in the development step after the printing plate has been exposed to light.

Examples of the addition polymerizable compound (b) having at least one ethylenically unsaturated double bond, used in the present invention, include unsaturated acids, such as acrylic acid, methacrylic acid, itaconic acid, maleic acid, maleic anhydride, phthalic acid, phthalic anhydride and fumaric acid; esters of unsaturated acids, such as methyl (meth)acrylate, ethyl (meth)acrylate, butyl (meth)acrylate, glycidyl (meth)acrylate, hydroxyethyl (meth)acrylate, dimethyl maleate, diethyl maleate, dimethyl fumarate, pentaerythritol tri(meth)acrylate, trimethylolpropane tri(meth)acrylate, ethyleneglycol di(meth)acrylate and propyleneglycol di(meth)acrylate; vinyl compounds such as styrene, acrylamide, acrylonitrile, N-vinylpyrrolidone and vinyl acetate; and various other compounds such as unsaturated polyesters, unsaturated polyethers, unsaturated polyurethanes and (meth)acrylate compounds having epoxide groups.

The polyperoxy ester (c) used in the present invention contains a benzophenone group and represented by the following general formula (I):

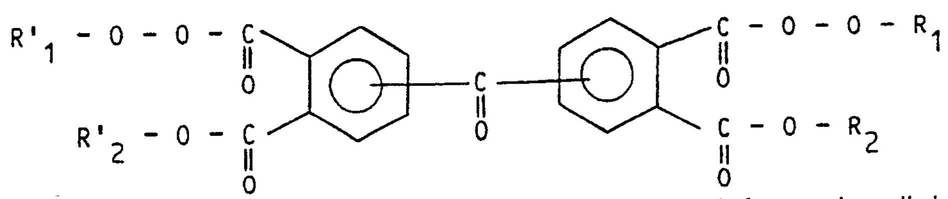

(I)

wherein $R_1$ and $R_1'$ each represents the same or different group and stands for a tertiary alkyl group having 4 to 8 carbon atoms or a tertiary aralkyl group having 9 to 12 carbon atoms, and $R_2$ and $R_2'$ each represents the same or different atom or group and stands for a hydrogen atom, a tertiary alkoxy group having 4 to 8 carbon atoms or a tertiary aralkyloxy group having 9 to 12 carbon atoms.

Specific examples of the polyperoxy ester containing a benzophenone group, which are used in the photosensitive layer of the invention are
3,3',4,4'-tetra-(t-butylperoxycarbonyl)benzophenone,
3,3',4,4'-tetra-(t-amylperoxycarbonyl)benzophenone,
3,3',4,4'-tetra-(t-hexylperoxycarbonyl)benzophenone,
3,3',4,4'-tetra-(t-octylperoxycarbonyl)benzophenone,
3,3',4,4'-tetra-(t-cumylperoxycarbonyl)benzophenone,
3,3',4,4'-tetra-(p-isopropylcumylperoxycarbonyl)benzophenone.

The pyrylium salt compound (d) absorbing visible light used in the invention is represented by the following general formula (II):

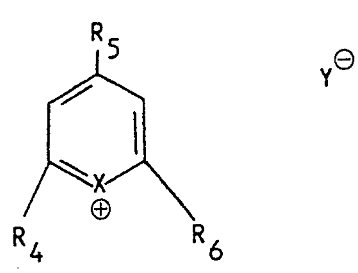

(II)

wherein $R_4$, $R_5$ and $R_6$ each represents the same or different atom or group and stands for a hydrogen atom, a halogen atom, an alkyl group, a haloalkyl group, an ethylenyl group, a styryl group, an alkoxy group, a phenyl group, a naphthyl group, an alkyl-phenyl group, an alkoxyphenyl group, a hydroxyphenyl group, a halophenyl group, a nitrophenyl group, an aminophenyl group, a nitro group, an amino group or a hydroxyl group, X stands for an oxygen atom or a sulfur atom, and Y stands for an anionic functional group.

The pyrylium salt compounds used in the present invention are pyrylium salts represented by the formula (II) wherein X is oxygen, and thiopyrylium salts represented by the formula (II) wherein X is sulfur, the anionic functional groups represented by Y in the formula (II) include, for example, perchlorate, fluoroborate, chloroaluminate, chloropherate, sulfuracetate, methosulfate, fluoroantimonate, thiocyanate, etc.

Specific examples of the pyrylium salt compounds which are used as the compound (d) in the invention are:
2,4,6-triphenylthiopyrylium fluoroborate,
2,4,6-triphenylthiopyrylium fluoroantimonate,
2,4,6-triphenylpyrylium perchlorate,
4-(4-methoxyphenyl)-2,6-diphenylpyrylium perchlorate,
2,6-bis(4-methoxyphenyl)-4-phenylpyrylium perchlorate,
4-(4-butoxyphenyl)-2,6-diphenylpyrylium perchlorate,
4-(4-amyloxyphenyl)-2,6-bis(4-ethylphenyl)pyrylium perchlorate,
2,4,6-triphenylpyrylium fluoroborate,
4-(4-butoxyphenyl)-2,6-di(4-methoxyphenyl)thiopyrylium fluoroborate,
2,4,6-triphenylthiopyrylium perchlorate,
4-(4-methoxyphenyl)-2,6-diphenylthiopyrylium perchlorate,
6-(4-ethoxyphenyl)-2,4-diphenylthiopyrylium perchlorate,
2,4,6-tri(4-methoxyphenyl)thiopyrylium perchlorate,
4-(4-methoxyphenyl)-2,6-diphenylpyrylium fluoroborate,
2,6-bis(4-methoxyphenyl)-4-phenylpyrylium fluoroborate,
4-(4-amyloxyphenyl)-2,6-bis(4-ethylphenyl)thiopyrylium perchlorate,
2,4,6-triphenylthiopyrylium sulfate,
4-(4-methoxyphenyl)-2,6-diphenylthiopyrylium fluoroborate,
2-(4-amyloxyphenyl)-4,6-diphenylthiopyrylium fluoroborate,
4-(4-amyloxyphenyl)-2,6-bis(4-methoxyphenyl)thiopyrylium perchlorate,
4-(4-methoxyphenyl)-2,6-bis(4-ethylphenyl)thiopyrylium perchlorate,
4-(2,4-dichlorophenyl)-2,6-diphenylpyrylium perchlorate,
2-(3,4-dichlorophenyl)-4-(4-methoxyphenyl)-6-phenylpyrylium perchlorate,
4-(4-amyloxyphenyl)-2,6-bis(4-ethylphenyl)pyrylium perchlorate,
2,6-bis(4-ethylphenyl)-4-(4-methoxyphenyl)pyrylium fluoroborate,
6-(3,4-diethoxystyryl)-2,4-diphenylpyrylium perchlorate,
6-(4-dimethylamino-β-ethylstyryl)-2,4-diphenylpyrylium fluoroborate,
6-(4-dimethylaminostyryl)-2,4-diphenylpyrylium perchlorate,
6-(β-methyl-4-dimethylaminostyryl)-2,4-diphenylpyrylium fluoroborate,
6-(β,β-bis(4-dimethylaminophenyl)vinylene)-2,4-diphenylpyrylium fluoroborate,
4-(4-dimethylaminophenyl)-2,6-diphenylpyrylium perchlorate,
2,6-bis(4-ethylphenyl)-4-methoxyphenylthiopyrylium fluoroborate,
2-amino-4,6-bis(4-methoxy-β-ethylstyryl)thiopyrylium fluoroborate, and
4-(4-dimethylaminostyryl)-6-(β,β-bis(4-dimethylaminophenyl)vinylene)thiopyrylium perchlorate.

The photosensitive lithographic printing plate of the invention may be prepared by coating a supporting substrate with a photosensitive layer containing the aforementioned polymer (a) having an acid number of not more than 200, the aforementioned addition polymerizable compound (b) having at least one ethylenically unsaturated double bond, the aforementioned peroxy ester containing a benzophenone group (c) and the aforementioned pyrylium salt compound (d) absorbing visible light. In a preferable composition each of the aforementioned components are mixed in a ratio such that 100 parts by weight of the component (a) is mixed with 10 to 200 parts by weight of the component (b), 0.1 to 10 parts by weight of the component (c) and 0.1 to 10 parts by weight of the component (d). The photosensitive composition may be dissolved in a solvent for dissolving all of the components, such as methyl cellolsolve, ethyl cellosolve, methyl ethyl ketone, isopropyl alcohol, butyl acetate, toluene, xylene, or butanol to form a uniform solution, which is coated over the supporting substrate through a bar coating, roller coating or spin coating method to form a coating layer having a thickness of from 0.1 to 10 μm followed by drying. Materials used for the supporting substrate include thin plates of metals, such as aluminum and zinc, sheets of plastics materials, such as polyvinyl chloride and polyethylene terephthalate and paper.

When the thus prepared photosensitive lithographic printing plate of the invention is exposed to light, the photosensitive layer being sensitive to light rays having widely spread wavelengths ranging from the ultraviolet range to the visible light range, the portions irradiated by the light rays are changed to be insoluble to a solvent within an extremely short exposure time so that the printing areas may be left on the

supporting substrate by developing with the use of an aqueous weak alkali solution after the selective exposure.

Since the photosensitive composition used in the photosensitive lithographic printing plate of the invention has an extremely high sensitivity even to a visible light laser, such as the $Ar^+$ laser, the printing plate of the invention is adapted to form an image by a high speed scanning exposure with a visible light laser of low output. The thus formed latent image may be easily developed by the use of an ordinary aqueous developing solution, and the printing areas left after the developing step may be well applied with a printing ink to form a clear printed image.

The present invention will be described more in detail hereinafter with reference to some Examples and Comparative Examples. Incidentally, parts and % are based on weight unless otherwise indicated.

Example 1

An surface of an aluminum plate was coarsened by sand blasting and then oxidized by anodic oxidation. A solution of a photosensitive composition prepared by the following formulation was coated over the pretreated aluminum plate using a whirler, and then dried at 60°C for 5 minutes to form a coating having a thickness of 2 μm.

Formulation of the Photosensitive Composition Solution:

| | |
|---|---|
| Acrylic Polymer* (Acid Number: 98) | 100 parts |
| Pentaerythritol Triacrylate | 60 parts |
| Di-t-butyldiperoxy Isophthalate | 3 parts |
| 4-(4-butoxyphenyl)-2,6-di(4-methoxyphenyl) thiopyrylium Fluoroborate | 3 parts |
| Hydroquinone | 1 part |
| Ethyl Cellosolve | 900 parts |

* Note: The used acrylic polymer was a copolymer of methyl methacrylate (MM), ethyl acrylate (EA), benzyl methacrylate (BM) and methacrylic acid (MA) mixed in a ratio of MM/EA/BM/MA = 30/25/30/15 and having a weight average molecular weight of 100,000.

The thus prepared photosensitive lithographic printing plate was exposed to a scanning exposure of a light ray having a wavelength and 488 nm and generated as an $Ar^+$ laser of an output of 10 mW, the laser light ray being focused to form a spot light of 25 μm in diameter, at a scanning rate of 5.1 m/sec. After the scanning exposure, the plate was subjected to a development step effected by using a 3% aqueous solution of sodium metasilicate for one minute to obtain a lithographic printing plate having clear printing areas which are left as the result of exposure by the laser light ray. An emulsion type printing ink was applied on the printing plate to reveal that the ink was spread uniformly in fully satisfactory condition.

Example 2

Generally in accordance with the procedures as described in Example 1 except that 2,6-bis(4-methoxyphenyl)-4-phenylpyrylium perchlorate was used as the compound for absorbing visible light, a photosensitive lithographic printing plate was prepared and exposed to a similar $Ar^+$ laser followed by development to obtain a lithographic printing plate. The resultant printing plate has clear printing areas comparable with those of the printing plate of Example 1, and the ink was spread uniformly in fully satisfactory condition on the printing areas.

Comparative Examples 1 to 6

The compositions similar to the compositions of Examples 1 to 6 except that the compounds for absorbing visible light were excluded from respective formulations were not sensitive to the $Ar^+$ laser having a wavelength of 488 nm to leave no images.

Comparative Examples 7 to 12

The compositions similar to the compositions of Examples 1 to 6 except that the organic peroxides were excluded from respective formulations were not sensitive to the $Ar^+$ laser having a wavelength of 488 nm to leave no images even after scanning with that laser beam.

Examples 3 and 4

Generally in accordance with the procedures as described in Example 1, solutions of photosensitive compositions having the following formulation were prepared. Acrylic Polymer (100 parts) Acid Number: 65.

The acrylic polymer used was a copolymer of methyl methacrylate (MM), ethyl acrylate (EA), butyl methacrylate (BM) and methacrylic acid (MA) prepared from a mixture of MM/EA/BM/MA = 30/20/30/10 and having a weight average molecular weight of 10,000.

| | |
|---|---|
| Pentaerythritol Triacrylate | 70 parts |
| 3,3',4,4'-tetra(t-butylperoxycarbonyl) benzophenone | 5 parts |
| Visible Light Absorbing Compound | 5 parts |
| Hydroquinone | 1 part |
| Ethyl Cellosolve | 800 parts |

In Examples, the following compounds were used as the visible light absorbing compounds:

Example 3: 4-(4-buitoxyphenyl)-2,6-diphenylthiopyrylium fluoroborate
Example 4: 4-(4-butoxyphenyl)-2,6-di(4-methoxyphenylpyrylium fluoroborate

All tests were performed similar to Example 1, using the photosensitive compositions as set above, respectively.

**Claims**

1. A photosensitive lithograhic printing plate comprising a supporting substrate and a photosensitive layer carried on said supporting substrate, said photosensitive layer containing a polymer (a) having an acid number of not more than 200, an addition polymerizable compound (b) having at least one ethylenically unsaturated double bond, an organic peroxide (c) and a compound (d) absorbing visible light, characterized in that said organic peroxide (c) is a polyperoxy ester containing a benzophenone group and represented by the following general formula (I):

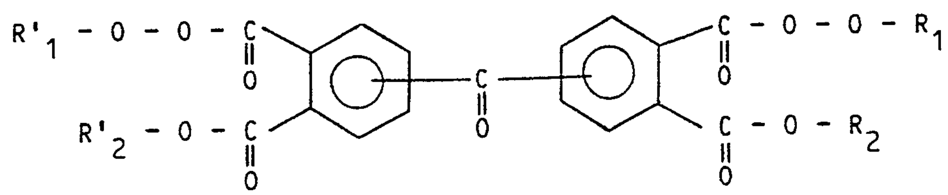

(I)

wherein each of $R_1$ and $R_1'$ represents the same or a different group and is a tertiary alkyl group having 4 to 8 carbon atoms or a tertiary aralkyl group having 9 to 12 carbon atoms, and each of $R_2$ and $R_2'$ represents the same or different atom or group and is a hydrogen atom, a tertiary alkoxy group having 4 to 8 carbon atoms or a tertiary aralkyloxy group having 9 to 12 carbon atoms, and said compound (d) absorbing visible light is a pyrylium salt compound represented by the following general formula (II):

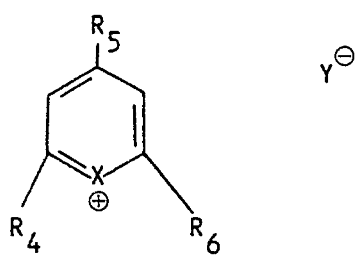

(II)

wherein each of $R_4$, $R_5$ and $R_6$ represents the same or different atom or group and is a hydrogen atom, a halogen atom, an alkyl group, a haloalkyl group, an ethylenyl group, a styryl group, an alkoxy group, a phenyl group, a naphthyl group, an alkylphenyl group, an alkoxyphenyl group, a hydroxyphenyl group, a halophenyl group, a nitrophenyl group, an aminophenyl group, a nitro group, an amino group or a hydroxyl group, X is an oxygen atom or a sulfur atom, and Y is an anionic functional group.

2. A photosensitive lithographic printing plate according to claim 1, wherein said polymer (a) having an acid number of not more than 200 is a polymer having a weight average molecular weight of about 10,000

to 500,000 and selected from the group consisting of vinyl system addition polymerization polymers, polyester system condensation polymers, polyurethane system condensation polymers, polyamide system condensation polymers and mixtures thereof.

3. A photosensitive lithographic printing plate according to claim 1 or 2, wherein said polymer (a) is a copolymer copolymerized with a monomer selected from the group consisting of acrylic acid, methacrylic acid, acrylates, methacrylates, maleic acid, fumaric acid, maleates, fumarates, ethylene glycol, styrene, vinyl chloride and mixtures thereof.

4. A photosensitive lithographic printing plate according to claim 3, wherein said copolymer is selected from the group consisting of copolymers of methyl methacrylate/ethyl acrylate/benzyl methacrylate/methacrylic acid, copolymers of methyl methacrylate/butyl methacrylate/methacrylic acid, copolymers of styrene/maleic acid/dimethyl maleate/vinyl chloride, copolymers of tetrahydrophthalic anhydride/fumaric acid/diethylene glycol, copolymers of methyl methacrylate/ethyl acrylate/butyl methacrylate/methacrylic acid and mixtures thereof.

5. A photosensitive lithographic printing plate according to any of the claims 1 to 4, wherein said addition polymerizable compound (b) having at least one ethylenically unsaturated double bond, is selected from the group consisting of acrylic acid, methacrylic acid, itaconic acid, maleic acid, and anhydride thereof, phthalic acid, and anhydride thereof, fumaric acid, methyl acrylate, methyl methacrylate, ethyl acrylate, ethyl methacrylate, butyl acrylate, butyl methacrylate, glycidyl acrylate, glycidyl methacrylate, hydroxyethyl acrylate, hydroxyethyl methacrylate, dimethyl maleate, diethyl maleate, dimethyl fumarate, pentaerythritol triacrylate, pentaerythritol trimethacrylate, trimethylolpropane triacrylate, trimethylolpropane trimethacrylate, ethyleneglycol diacrylate, ethyleneglycol dimethacrylate, propyleneglycol diacrylate, propyleneglycol dimethacrylate, styrene, acrylamide, acrylonitrile, N-vinyl pyrrolidone, vinyl acetate, unsaturated polyester, unsaturated polyethers, unsaturated polyurethanes, acrylate compounds having epoxide groups, methacrylate compounds having epoxide groups, and mixtures thereof.

6. A photosensitive lithographic printing plate according to any of the claims 1 to 5, wherein said polyperoxy ester containing a benzophenone group is selected from the group consisting of
3,3′,4,4′-tetra-(t-butylperoxycarbonyl)benzophenone,
3,3′,4,4′-tetra-(t-amylperoxycarbonyl)benzophenone,
3,3′,4,4′-tetra-(t-hexylperoxycarbonyl)benzophenone,
3,3′,4,4′-tetra-(t-octylperoxycarbonyl)benzophenone,
3,3′,4,4′-tetra-(cumylperoxycarbonyl)benzophenone,
3,3′,4,4′-tetra-(p-isopropylcumylperoxycarbonyl)benzophenone and mixtures thereof.

7. A photosensitive lithographic printing plate according to any of the claims 1 to 6, wherein said pyrylium salt compound is selected from the group consisting of:
2,4,6-triphenylthiopyrylium fluoroborate,
4-(4-methoxyphenyl)-2,6-diphenylpyrylium perchlorate,
2,6-bis(4-methoxyphenyl)-4-phenylpyrylium perchlorate,
4-(4-butoxyphenyl)-2,6-diphenylpyrylium perchlorate,
2,4,6-triphenylpyrylium fluoroborate,
4-(4-butoxyphenyl)-2,6-di(4-methoxyphenyl)thiopyrylium fluoroborate,
2,4,6-triphenylthiopyrylium perchlorate,
4-(4-methoxyphenyl)-2,6-diphenylthiopyrylium perchlorate,
4-(4-methoxyphenyl)-2,6-diphenylpyrylium fluoroborate,
2,6-bis(4-methoxyphenyl)-4-phenylpyrylium fluoroborate,
4-(4-methoxyphenyl)-2,6-diphenylthiopyrylium fluoroborate,
4-(4-amyloxyphenyl)-2,6-bis(4-methoxyphenyl)thiopyrylium perchlorate,
6-(4-dimethylamino-β-ethylstyryl)-2,4-diphenylpyrylium fluoroborate,
4-(4-dimethylaminophenyl)-2,6-diphenylpyrylium perchlorate,
and mixtures thereof.

8. A photosensitive lithographic printing plate according to any of the claims 1 to 7, wherein said photosensitive layer contains 100 parts by weight of said polymer (a) having an acid number of not more than 200, 10 to 200 parts by weight of said addition polymerizable compound (b) having at least one ethylenically unsaturated double bond, 0.1 to 10 parts by weight of said organic peroxide (c) and 0.1 to 10 parts by weight of said compound (d) absorbing visible light.

9. A photosensitive lithographic printing plate according to any of the claims 1 to 8, wherein said photosensitive layer has a thickness of from 0.1 to 10 µm.

10. A photosensitive lithographic printing plate according to any of the claims 1 to 9, wherein said supporting substrate is made of a material selected from the group consisting of metals, plastics, paper and combinations therof.

**Patentansprüche**

1. Lichtempfindliche lithographische Druckplatte mit einem substrat als Trägerschicht und einer lichtempfindlichen Schicht, die auf der Trägerschicht angeordnet ist, wobei die lichtempfindliche Schicht folgende Bestandteile enthält:

— ein Polymer (a) mit einer Säurezahl nicht größer als 200,

— eine Additions-polymerisierbare Verbindung (b) mit wenigstens einer ethylenisch ungesättigten Doppelbindung,

— ein organisches Peroxid (c) und

— eine sichtbares Licht absorbierende Verbindung (d), dadurch gekennzeichnet, daß das organische Peroxid (c) ein eine Benzophenon-Gruppe enthaltender Polyperoxyester der folgenden allgemeinen Formel (I) ist,

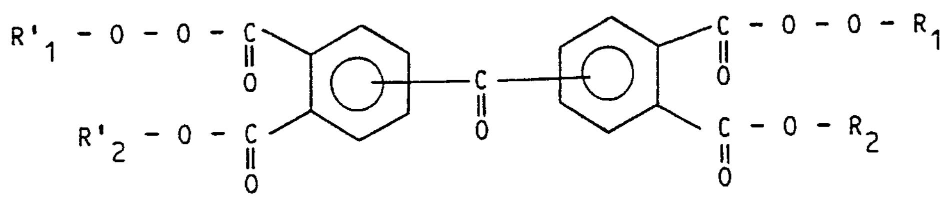

(I)

worin jede der Gruppen $R_1$ und $R_2'$ für gleiche oder unterschiedliche Gruppen stehen und eine tertiäre Alkylgruppe mit 4 bis 8 C-Atomen oder eine tertiäre Aralkylgruppe mit 9 bis 12 C-Atomen bedeuten und jede der Gruppen $R_2$ und $R_2'$ für gleiche oder unterschiedliche Gruppen stehen und ein Wasserstoffatom, eine tertiäre Alkoxygruppe mit 4 bis 8 C-Atomen oder eine tertiäre Aralkyloxygruppe mit 9 bis 12 C-Atomen bedeuten, und

die Licht absorbierende Verbindung (d) ein Pyryliumsalz der nachfolgenden allgemeinen Formel (II) ist,

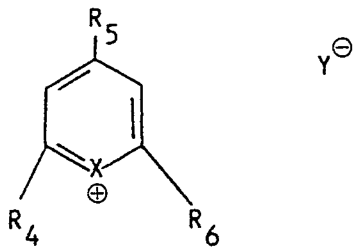

(II)

worin die Reste $R_4$, $R_5$ und $R_6$ für gleiche oder unterschiedliche Atome oder Gruppen stehen und ein Wasserstoffatom, ein Halogenatom, eine Alkylgruppe, eine Halogenalkylgruppe, eine Ethenylgruppe, eine Styrylgruppe, eine Alkoxygruppe, eine Phenylgruppe, eine Naphthylgruppe, eine Alkylphenylgruppe, eine Alkoxyphenylgruppe, eine Hydroxyphenylgruppe, ein Halogenphenylgruppe, eine Nitrophenylgruppe, eine Aminophenylgruppe, eine Nitrogruppe, eine Aminogruppe oder eine hydroxygruppe bedeuten, und X für ein Sauerstoffatom oder eine Schwefelatom und Y für ein anionische funktionelle Gruppe stehen.

2. Lichtempfindliche lithographische Druckplatte nach Anspruch 1, worin das Polymer (a) mit einer Säurezahl nicht über 200 ein Polymer ist, das ein Gewichtsmittel des Molekulargewichts im Bereich von 10.000 bis 500.000 aufweist und ausgewählt ist aus der Gruppe der nachfolgenden Polymeren: Vinyl-artige Polymere für die Additionspolymerisation, Polyester-artige Kondensationspolymere, Polyurethan-artige Kondensationspolymere, Polyamidartige Kondensationspolymere und deren Mischungen.

3. Lichtempfindliche lithographische Druckplatte nach einem der Ansprüche 1 oder 2, worin das Polymer (a) ein Copolymer ist, das mit einem Monomer aus der Gruppe Acrylsäure, Methacrylsäure, Acrylate, Methacrylate, Maleinsäure, Fumarsäure, Maleate, Fumarate, Ethylenglykol, Styrol, Vinylchlorid und deren Mischungen copolymerisiert ist.

4. Lichtempfindliche lithographische Druckplatte nach Anspruch 3, worin das Copolymer ausgewählt ist aus der Gruppe bestehend aus Copolymeren von Methylmethacrylat, Ethylacrylat, Benzylmethacrylat und Methacrylsäure, Copolymeren aus Methylmethacrylat, Butylmethacrylat und Methacrylsäure, Copolymeren aus Styrol, Maleinsäure, Dimethylmaleat und Vinylchlorid, Copolymeren aus Tetrahydrophthalsäureanhydrid, Fumarsäure und Diethylenglykol, Copolymeren aus Methylmethacrylat, Ethylacrylat, Butylmethacrylat und Methacrylsäure und deren Mischungen.

5. Lichtempfindliche lithographische Druckplatte nach einem der Ansprüche 1 bis 4, worin die Additions-polymerisierbare Verbindung (b) mit wenigstens einer ethylenisch ungesättigten Doppelbindung ausgewählt ist aus der folgenden Gruppe von Verbindungen: Acrylsäure, Methacrylsäure, Itaconsäure, Maleinsäure und deren Anhydrid, Phthalsäure und deren Anhydrid, Fumarsäure, Methylacrylat, Methylmethacrylat, Ethylacrylat, Ethylmethacrylat, Butylacrylat, Butylmethacrylat, Glycidylacrylat, Glycidylmethacrylat, Hydroxyethylacrylat, Hydroxyethylmethacrylat, Dimethylmaleat, Diethylmaleat, Dimethylfumarat, Pentaerythrittriacrylat, Pentaerythrittrimethacrylat, Trimethylolpropantriacrylat, Trimethylolpropantrimethacrylat, Ethylenglykoldiacrylat, Ethylenglykoldimethacrylat,

Propylenglykoldiacrylat, Propylenglykoldimethacrylat, Styrol, Acrylamid, Acrylnitril, N-Vinylpyrrolidon, Vinylacetat, ungesättigte Polyester, ungesättigte Polyether, ungesättigte Polyurethane, Acrylatverbindungen mit Epoxygruppen, Methacrylatverbindungen mit Epoxygruppen und deren Mischungen.

6. Lichtempfindliche lithographische Druckplatte nach einem der Ansprüche 1 bis 5, worin der eine Benzophenon-Gruppe enthaltende Polyperoxyester ausgewählt ist aus der Gruppe der folgenden Verbindungen:
3,3',4,4'-Tetra-(t-butylperoxycarbonyl)benzophenon,
3,3',4,4'-Tetra-(t-amylperoxycarbonyl)benzophenon,
3,3',4,4'-Tetra-(t-hexylperoxycarbonyl)benzophenon,
3,3',4,4'-Tetra-(t-octylperoxycarbonyl)benzophenon,
3,3',4,4'-Tetra-(cumylperoxycarbonyl)benzophenon,
3,3',4,4'-Tetra-(p-isopylcumylperoxycarbonyl)benzophenon und deren Mischungen.

7. Lichtempfindliche lithographische Druckplatte nach einem der Ansprüche 1 bis 6, worin das Pyryliumsalz ausgewählt ist aus der Gruppe der folgenden Verbindungen:
2,4,6-Triphenylthiopyryliumfluorborat, 4-(4-Methoxyphenyl-)2,6-diphenylpyryliumperchlorat, 2,6-Bis(4-methoxyphenyl)-4-phenylpyryliumperchlorat, 4-(4-Butoxyphenyl)-2,6-diphenylpyryliumperchlorat, 2,4,6-Triphenylpyryliumfluorborat, 4-(4-Butoxyphenyl)-2,6-di(4-methoxyphenyl)thiopyryliumfluorborat, 2,4,6-Triphenylthiopyryliumperchlorat, 4-(4-Methoxyphenyl)-2,6-diphenylthiopyryliumperchlorat, 4-(4-Methoxyphenyl)-2,6-diphenylpyryliumfluorborat, 2,6-Bis(4-methoxyphenyl)-4-phenylpyryliumfluorborat, 4-(4-Methoxyphenyl)-2,6-diphenylthiopyryliumfluorborat, 4-(4-Amyloxyphenyl)-2,6-bis(4-methoxyphenyl)thiopyryliumperchlorat, 6-(4-Dimethylamino-β-ethylstyryl)-2,4-diphenylpyryliumfluorborat, 4-(4-Dimethylaminophenyl)-2,6-diphenylpyryliumperchlorat, und deren Mischungen.

8. Lichtempfindliche lithographische Druckplatte nach einem der Ansprüche 1 bis 7, worin die lichtempfindliche Schicht 100 Gew.-Teile des Polymers (a) mit einer Säurezahl nicht über 200, 10 bis 200 Gew.-Teile der Additionspolymerisierbaren Verbindung (b) mit wenigstens einer ethylenisch ungesättigten Doppelbindung, 0,1 bis 10 Gew.-Teile des organischen Peroxids (c) und 0,1 bis 10 Gew.-Teile der sichtbares Licht absorbierenden Verbindung (d) enthält.

9. Lichtempfindliche lithographische Druckplatte nach einem der Ansprüche 1 bis 8, worin die lichtempfindliche Schicht eine Dicke im Bereich vom 0,1 bis 10 µm hat.

10. Lichtempfindliche lithographische Druckplatte nach einem der Ansprüche 1 bis 9, worin das Trägersubstrat aus einem der Materialien aus der Gruppe Metalle, Kunststoffe, Papier und deren Kombinationen besteht.

**Revendications**

1. Une plaque d'impression lithographique photosensible comprenant un substrat de support et une couche photosensible portée par ledit substrat de support, ladite couche photosensible contenant un polymère (a) ayant un indice d'acide ne dépassant pas 200, un composé polymérisable d'addition (b) ayant au moins une double liaison éthyléniquement insaturée, un composé peroxyde (c) et un composé (d) absorbant la lumière visible, caractérisée en ce que ledit peroxyde organique (c) est un polyperoxyester contenant un groupe benzophénone et représenté par la formule générale (I):

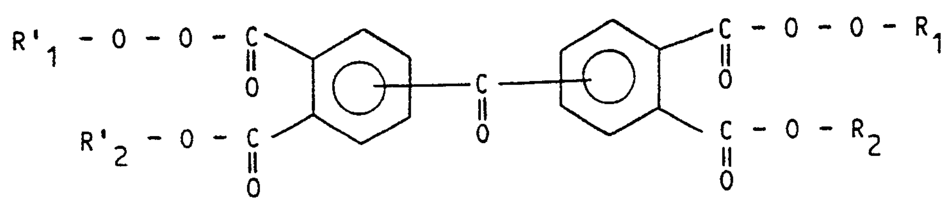

(I)

dans laquelle $R_1$ et $R'_1$ peuvent être identiques ou différents et représentent chacun un groupe alkyle tertiaire ayant 4 à 8 atomes de carbone ou un groupe aralkyle tertiaire ayant 9 à 12 atomes de carbone, et $R_2$, $R'_2$ peuvent être identiques ou différents et représentent chacun un atome d'hydrogène, un groupe alcoxy tertiaire ayant 4 à 8 atomes de carbone ou un groupe aralcoxy tertiare ayant 9 à 12 atomes de carbone, et ledit composé (d) absorbant la lumière visible est un composé de sel de pyrylium représenté par la formule générale (II):

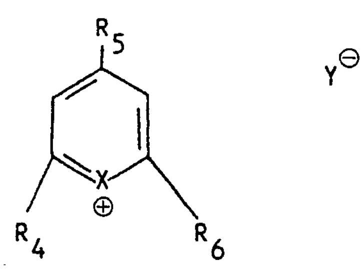

(II)

dans laquelle $R_4$, $R_5$ et $R_6$ peuvent être identiques ou différents et représentent chacun un atome d'hydrogène, un atome d'halogène, un groupe alkyle, un groupe haloalkyle, un groupe éthylényle, un groupe styryle, un groupe alcoxy, un groupe phényle, un groupe naphtyle, un groupe alkylphényle, un groupe alcoxyphényle, un groupe hydroxyphényle, un groupe halophényle, un groupe nitrophényle, un groupe aminophényle, un groupe nitro, un groupe amino ou un groupe hydroxyle, X est un atome d'oxygène ou un atome de soufre et Y est un groupe fonctionnel anionique.

2. Une plaque d'impression lithographique photosensible selon la revendication 1, selon laquelle ledit polymère (a) ayant un indice d'acide ne dépassant pas 200 est un polymère ayant un poids moléculaire moyen en poids de 10 000 à 500 000 et choisi dans le groupe comprenant les polymères de polymérisation d'addition du système vinylique, les polymères de condensation du système polyester, les polymères de condensation du système polyuréthanne, les polymères de condensation du système polyamide et leurs mélanges.

3. Une plaque d'impression lithographique photosensible selon la revendication 1 ou 2, selon laquelle polymère (a) est un copolymère copolymérisé avec un monomère choisi dans le groupe comprenant l'acide acrylique, l'acide méthacrylique, les acrylates, les méthacrylates, l'acide maléique, l'acide fumarique, les maléates, les fumarates, l'éthylèneglycol, le styrène, le chlorure de vinyle et leurs mélanges.

4. Une plaque d'impression lithographique photosensible selon la revendication 3, selon laquelle ledit copolymère est choisi dans le groupe comprenant les copolymères de méthacrylate de méthyle/acrylate d'éthyle/méthacrylate de benzyle/acide méthacrylique, les copolymères de méthacrylate de méthyle/méthacrylate de butyle/acide méthacrylique, les copolymères de styrène/acide maléique/maléate de diméthyle/chlorure de vinyle, les copolymères d'anhydride tétrahydrophtalique/acide fumarique/di-éthylèneglycol, les copolymères de méthacrylate de méthyle/acrylate d'éthyle/méthacrylate de butyle/acide méthacrylique et leurs mélanges.

5. Une plaque d'impression lithographique photosensible selon l'une quelconque des revendications 1 à 4, selon laquelle ledit composé polymérisable d'addition (b) ayant au moins une double liaison éthyléniquement insaturée est choisi dans le groupe suivant : acide acrylique, acide méthacrylique, acide itaconique, acide maléique et son anhydride, acide phtalique et son anhydride, acide fumarique acrylate de méthyle, méthacrylate de méthyle, acrylate d'éthyle, méthacrylate d'éthyle, acrylate de butyle, méthacrylate de butyle, acrylate de glycidyle, méthacrylate de glycidyle, acrylate d'hydroxyéthyle, méthacrylate d'hydroxyéthyle, maléate de diméthyle, maléate de diéthyle, fumarate de diméthyle, triacrylate de pentaérythritol, triméthacrylate de pentaérythritol triacrylate de triméthylolpropane, triméthacrylate de triméthylolpropane, diacrylate d'éthylèneglycol, diméthacrylate d'éthylèneglycol, diacrylate de propylèneglycol, diméthacrylate de propylèneglycol, styrène, acrylamide, acrylonitrile, N-vinylpyrrolidone, acétate de vinyle, polyesters insaturés, polyéthers insaturés, polyuréthannes insaturés, composés acrylates contenant des groupes époxydes, composés méthacrylates contenant des groupes époxydes et leurs mélanges.

6. Un plaque d'impression lithographique photosensible selon l'une quelconque des revendications 1 à 5, selon laquelle ledit polyperoxyester contenant un groupe benzophénone est choisi dans le groupe comprenant les suivants:
3,3',4,4'-tétra-(t-butylperoxycarbonyl)benzophénone,
3,3',4,4'-tétra-(t-amylperoxycarbonyl)benzophénone,
3,3',4,4'-tétra-(t-hexylperoxycarbonyl)benzophénone,
3,3',4,4'-tétra-(t-octylperoxycarbonyl)benzophénone,
3,3',4,4'-tétra-(cumylperoxycarbonyl)benzophénone,
3,3',4,4'-tétra-(p-isopropylcumylperoxycarbonyl)benzophénone et leurs mélanges.

7. Une plaque d'impression lithographique photosensible selon l'une quelconque des revendications 1 à 6, selon laquelle ledit sel de pyrylium est choisi dans le groupe comprenant les suivants:
fluoroborate de 2,4,6-triphénylpyrylium,
perchlorate de 4-(4-méthoxyphényl)-2,6-diphénylpyrylium,
perchlorate de 2,6-bis(4-méthoxyphényl)-4-phénylpyrylium,
perchlorate de 4-(4-butoxyphényl)-2,6-diphénylpyrylium,
fluoroborate de 2,4,6-triphénylpyrylium,
fluoroborate de 4-(4-butoxyphényl)-2,6-di(4-méthoxyphényl)thiopyrylium,
perchlorate de 2,4,6-triphénylthiopyrylium,
perchlorate de 4-(4-méthoxyphényl)-2,6-diphénylthiopyrylium,
fluoroborate de 4-(4-méthoxyphényl)-2,6-diphénylpyrylium,
fluoroborate de 2,6-bis(4-méthoxyphényl)-4-phénylpyrylium,
fluoroborate de 4-(4-méthoxyphényl)-2,6-diphénylthiopyrylium,
perchlorate de 4-(4-amyloxyphényl)-2,6-bis(4-méthoxyphényl)thiopyrylium,
fluoroborate de 6-(4-diméthylamino-β-éthylstyryl)-2,4-diphénylpyrylium,
perchlorate de 4-(4-diméthylaminophényl)-2,6-diphénylpyrylium, et leurs mélanges.

8. Une plaque d'impression lithographique photosensible selon l'une quelconque des revendications 1 à 7, selon laquelle la couche photosensible contient 100 parties en poids dudit polymère (a) ayant un indice d'acide ne dépassant pas 200, 10 à 200 parties en poids dudit composé polymérisable d'addition (b) ayant au moins une double liaison éthyléniquement insaturée, 0,1 à 10 parties en poids dudit peroxyde

organique (c) et 0,1 à 10 parties en poids dudit composé (d) absorbant la lumière visible.

9. Une plaque d'impression lithographique photosensible selon l'une quelconque des revendications 1 à 8, selon laquelle ladite couche photosensible a une épaisseur de 0,1 à 10 µm.

10. Une plaque d'impression lithographique photosensible selon l'une quelconque des revendications 1 à 9, selon laquelle ledit substrat de support est réalisé en un matériau choisi dans le groupe comprenant les métaux, les matières plastiques, le papier et une combinaison de ceux-ci.